# EUROPÄISCHE PATENTANMELDUNG

(11) **EP 1 601 105 A1**
(43) Veröffentlichungstag der Anmeldung: **30.11.2005**
(21) Anmeldenummer: 05009270.9
(22) Anmeldetag: 28.04.2005
(51) Int. Cl.: H03K 17/965

(54) **Vorrichtung und Verfahren zur Sicherung eines Haushaltsgeräts vor unbeabsichtigtem Betrieb**

(30) Priorität: 26.05.2004 DE 102004026315
(71) Anmelder: Electrolux Home Products Corporation N.V., 1930 Zaventem (BE)
(72) Erfinder: Tripon, Stefan Ioan, 440271 Satu Mare (RO)
(74) Vertreter: Hochmuth, Jürgen

(57) **Zusammenfassung**

Die Erfindung betrifft eine Vorrichtung und ein Verfahren zur Sicherung eines Haushaltsgeräts, insbesondere eines E-lektroherds, vor unbeabsichtigtem Betrieb. Die Vorrichtung umfasst wenigstens ein Betätigungselement und wenigstens eine mit dem wenigstens einen Betätigungselement zusammenwirkende elektrische Schalteinrichtung mit einer Zeitverzögerungsfunktion, wobei durch Betätigen des wenigstens einen Betätigungselements über eine vorgegebene oder vorgebbare Mindest-Betätigungsdauer in wenigstens einem Teilbereich des Haushaltsgeräts durch die Schalteinrichtung eine Stromversorgung unterbrechbar bzw. unterbrochen oder herstellbar bzw. hergestellt ist oder wenigstens eine Schaltfunktion für das Haushaltsgerät blockierbar bzw. blockiert oder freigebbar bzw. freigegeben ist.

## Beschreibung

Die Erfindung betrifft eine Vorrichtung und ein Verfahren zur Sicherung eines Haushaltsgeräts, insbesondere eines Haushaltsgargeräts bzw. Haushaltsgarofens, vor unbeabsichtigtem Betrieb.

Haushaltsgargeräte bzw. Haushaltsgaröfen verfügen in der Regel über ein Kochfeld mit mehreren Kochplatten oder Kochzonen und einem Back-, Gar- oder Bratofen. Die Ansteuerung und Regelung der einzelnen Teilbereiche kann über an einer Bedienblende bzw. Bedienfläche des Haushaltsgeräts angeordnete Druck- oder Drehschalter erfolgen, wobei ein Schalter wenigstens einem Teilbereich des Haushaltsgargeräts bzw. Haushaltsgarofens, z.B. einer Kochplatte oder -zone zugeordnet sein kann.

Solch ein Haushaltsgerät ist aus Sicherheitsgründen generell vor unbeabsichtigten Betrieb zu schützen. Ein unbeabsichtigter Betrieb kann sowohl ein ungewolltes Inbetriebsetzen des Haushaltsgeräts als auch das Verstellen bereits vorgenommener Einstellung am Haushaltsgerät umfassen. Insbesondere ist darauf zu achten, dass nicht befugte Personen wie Kinder oder auch erwachsene Personen beispielweise mit Demenz-Erkrankungen am Haushaltsgerät keine unerwünschten Einstellungen vornehmen können. Wird das Haushaltgerät von einer nicht befugten Person unbeobachtet eingeschaltet, so kann dass dazu führen, dass eine befugte Bedienperson sich beispielsweise an einer heißen Kochzone verbrennt oder dass auf oder in dem Haushaltgerät befindliche Gegenstände beschädigt werden und sich im Extremfall sogar entzünden können.

Aus dem Stand der Technik sind verschiedene Verfahren oder Vorrichtungen zur Sicherungen vor unbeabsichtigtem Betrieb bekannt. Neben den mechanischen Sicherungseinrichtungen, die einen Zugriff auf die Bedienelemente wie Schalter oder Tasten versperren, sind beispielsweise Verfahren bekannt, bei denen durch nacheinander oder gleichzeitig durchgeführte Betätigungskombinationen an den Bedienelementen das Haushaltsgerät für eine Bedienung gesperrt, beispielsweise durch Unterbrechung der Stromversorgung oder Einschränken der Funktionsfähigkeit der Bedienelemente, oder wieder freigegeben werden kann. Die jeweils notwendigen Betätigungskombinationen können jedoch aufwändig in der Durchführung oder kompliziert zu merken sein. Solch eine Sicherungseinrichtung wird daher häufig nicht angewendet.

Aus DE 101 56 771 Al ist ein elektrisches Haushaltsgerät bekannt, das einen Hauptschalter in Touch-Control-Technik bzw. als Sensor-Einrichtung zum Ein- und Ausschalten der Stromversorgung umfasst, welcher eine vorbestimmte Einschalt-Betätigungsdauer aufweist, während der er mindestens betätigt werden muss, damit er von seiner Aus-Stellung auf seine Ein-Stellung umschaltet. Die Länge der zur Aktivierung des Hauptschalters erforderlichen Betätigungszeitdauer am fertigen Haushaltsgerät beim Kunden ist durch eine Bedienperson durch ein hierfür vorgesehenes Zeitdauer-Einstellmittel zwischen 0,5 und 5 s einstellbar.

Der Nachteil dieser Sicherungseinrichtung nach DE 101 56 771 Al ist jedoch, dass der Hauptschalter dennoch von einer unbefugten Person ein- oder ausgeschaltet werden kann, wenn die Person, beispielsweise ein Kind, versehentlich oder auch absichtlich eine längere Zeit mit dem Finger auf oder über der Schaltfläche verweilt. Darüber hinaus ist die beschriebene Sicherungseinrichtung nur für elektrische Haushaltsgeräte mit Sensorschaltflächen, beispielsweise Glaskochfeld bzw. Glasbedienblende, geeignet. Für die Mehrheit der Haushaltsgeräte, insbesondere auch preisgünstigere Modelle, ist diese Sicherungseinrichtung daher nicht geeignet.

Es ist nun Aufgabe der Erfindung, eine Vorrichtung und ein Verfahren zur Sicherung eines Haushaltsgeräts, insbesondere eines Haushaltsgargeräts bzw. Haushaltsgarofens, vor unbeabsichtigtem Betrieb, bereitzustellen, durch die vorgenannten Nachteile beim Stand der Technik wenigstens teilweise überwunden oder zumindest vermindert werden.

Diese Aufgabe wird hinsichtlich der Vorrichtung mit den Merkmalen des Patentanspruchs 1 und hinsichtlich des Verfahrens mit den Merkmalen des Patentanspruchs 14 gelöst. Vorteilhafte Ausgestaltungen und Weiterbildungen ergeben sich aus den von Anspruch 1 bzw. Anspruch 14 jeweils abhängigen Ansprüchen.

Die Vorrichtung gemäß Anspruch 1 zur Sicherung eines Haushaltsgeräts, insbesondere eines Haushaltsgargeräts bzw. Haushaltsgarofens, vor unbeabsichtigtem Betrieb, umfasst wenigstens ein Betätigungselement und wenigstens eine mit dem wenigstens einen Betätigungselement zusammenwirkende elektrische Schalteinrichtung mit einer Zeitverzögerungsfunktion. Durch Betätigen des wenigstens einen Betätigungselements über eine vorgegebene oder vorgebbare Mindest-Betätigungsdauer ist in wenigstens einem Teilbereich des Haushaltsgeräts durch die Schalteinrichtung eine Stromversorgung unterbrechbar bzw. unterbrochen oder herstellbar bzw. hergestellt oder wenigstens eine Schaltfunktion für das Haushaltsgerät blockierbar bzw. blockiert oder freigebbar bzw. freigegeben.

Die Vorrichtung umfasst vorzugsweise ein Betätigungselement das bevorzugt als Drucktaste oder Drehknebel oder Druck-Drehschalter ausgeführt sein kann. Das Haushaltsgerät kann aber auch mit einer Vorrichtung mit mehreren Betätigungselementen ausgestattet sein, die jeweils für die Sicherung eines Teilbereichs des Haushaltsgeräts vorgesehen sind. Unter dem Begriff Teilbereich des Haushaltgeräts ist beim'Elektroherd beispielsweise der gesamte Back-, Gar- oder Bratofen oder Teile hiervon sowie das gesamte Kochfeld oder einzelne Kochplatten bzw. -zonen zu verstehen.

Durch Betätigen des Betätigungselements kann dann die Stromversorgung für das gesamte Haushaltsgerät oder nur für einen Teilbereich abgetrennt bzw. unterbrochen und anschließend wieder hergestellt bzw. verbunden werden. Eine weitere Möglichkeit ist, dass nur eine Schaltfunktion für das Haushaltsgerät gesperrt bzw. blockiert oder freigegeben wird. Das Bedeutet, dass Bedienelemente, wie Tasten, Dreh- oder Druckschalter zur Temperaturregelung oder Funktionswahl nicht mehr auf Betätigung ansprechen und somit beispielsweise am Haushaltsgerät vorgenommene Einstellungen nicht verstellt werden können.

Bei dem Verfahren nach Anspruch 14 zur Sicherung eines Haushaltsgeräts, insbesondere eines Haushaltsgargeräts bzw. Haushaltsgarofens, vor unbeabsichtigtem Betrieb, insbesondere unter Verwendung einer Vorrichtung nach Anspruch 1 oder einem der fakultativ auf Anspruch 1 rückbezogenen Ansprüche, wirkt wenigstens ein Betätigungselement, vorzugsweise ein Druckschalter und/oder Drehschalter, bei Betätigung mit wenigstens einer elektrischen Schalteinrichtung mit einer Zeitverzögerungsfunktion zusammen, und wird bei Betätigen des Betätigungselements über eine vorgegebene oder vorgebbare Mindest-Betätigungsdauer in wenigstens einem Teilbereich des Haushaltsgeräts eine Stromversorgung unterbrochen oder hergestellt oder wenigstens eine Schaltfunktion für das Haushaltsgeräts blockiert oder freigegeben.

Ein Hauptvorteil der Vorrichtung und des Verfahrens gemäß der Erfindung ist, dass sich solch ein Betätigungselement zum Schutz vor unbeabsichtigtem Betrieb eines Elektrogeräts, das insbesondere als Drucktaste bzw. Druckschalter oder Drehknebel bzw. Drehschalter ausgeführt ist, auf einfache Weise an oder in der Bedienfläche eines herkömmlichen Haushaltsgerät anordnen lässt und damit relativ kostengünstig zu realisieren ist. Zudem ist ein Betätigungselement wie ein Druck- oder Drehschalter von der unbefugten Person, insbesondere einem Kleinkind, schwerer über eine längere Zeit zu betätigen als ein Sensorschalter. Darüber hinaus lassen sich bei der erfindungsgemäßen Vorrichtung auf einfache Weise zusätzliche Sicherheitsvorkehrungen treffen, die ein Betätigen des Betätigungselements verhindern oder zusätzlich erschweren.

Nach einem besonders bevorzugten Aspekt der Erfindung ist durch Betätigen des wenigstens einen Betätigungselements über eine vorgegebene oder vorgebbare Mindest-Betätigungsdauer die Hauptstromversorgung für das Haushaltsgerät unterbrechbar bzw. unterbrochen oder herstellbar bzw. hergestellt. Somit kann über einen einzigen Schalter das gesamte Haushaltsgerät außer Betrieb gesetzt oder bei bedarf wieder in Betrieb genommen werden.

Insbesondere bevorzugt ist es, wenn wenigstens eine Anzeigeeinheit, insbesondere wenigstens eine Lampe oder eine LED umfassend, vorgesehen ist, zum Anzeigen des aktuellen Betriebszustands des Haushaltsgeräts bzw. des Betätigungselements. Dabei kann es besonders vorteilhaft sein, wenn einem Betätigungselement wenigstens eine Lampe oder LED mit wenigstens zwei unterschiedlichen Leuchtfarben, insbesondere rot und grün, zugeordnet ist, zum Anzeigen einer unterbrochenen und einer hergestellten Stromversorgung durch das Betätigungselement. Auf diese Weise weiß der Bediener auf einen Blick, in welchem Betriebszustand sich das Haushaltsgerät bzw. das Betätigungselement befindet. Eine unterbrochen und eine verbundene Stromversorgung wird bevorzugt jeweils durch eine separate Leuchtfarbe, insbesondere rot und grün, angezeigt.

Besonders bevorzugt ist es, wenn als vorgegebene oder vorgebbare Mindest-Betätigungsdauer, um eine Schaltung auszulösen, wenigstens 2,0 s, vorzugsweise wenigstens 5,0 s, vorgesehen sind. Je länger das Betätigungselement gedreht oder gedrückt gehalten werden muss, umso schwerer ist es von einer unbefugten Person, insbesondere von Kindern, zu bedienen. Die Mindest-Betätigungsdauer kann vorzugsweise in einem vorgegebenen Bereich einstellbar sein, beispielsweise zwischen 2 und 15 s.

Nach einem besonders bevorzugten Aspekt der vorliegenden Erfindung sind das Betätigungselement und die elektrische Schalteinrichtung und/oder die wenigstens eine Anzeigeeinheit zu einer Einheit, insbesondere in einem Gehäuse, zusammengefasst. Die separate Einheit kann sowohl in oder auf die Bedienfläche ein-oder aufgesetzt werden, aber auch an jeder anderen Stelle am Haushaltsgerät oder entfernt vom Haushaltsgerät angebracht werden. Die separate Einheit ist dann vorzugsweise mit der Steuerungs- und Regelungseinrichtung für das Haushaltsgerät verbunden. Die separate Einheit kann neben der Vorrichtung zur Sicherung vor unbeabsichtigtem Betätigen des Haushaltsgeräts weitere Funktions- bzw. Bedienelemente wie eine Zeitschaltuhr, Programmiertasten, etc. umfassen.

Besonders bevorzugt ist es auch, wenn das Betätigungselement und/oder die wenigstens eine Anzeigeeinheit an einer Bedienfläche vorgesehen sind, damit sie vom befugten Bediener gut einsehbar sind. Bevorzugt ist das Betätigungselement von der Innenseite durch die Bedienfläche durchgeführt und schließt im Wesentlichen bündig mit einer Außenseite der Bedienfläche ab. In diesem Fall kann das Betätigungselement eine Drucktaste oder ein in der Bedienfläche versenkbarer Drehknebel bzw. Drehschalter sein. Der Vorteil ist dabei, dass das Betätigungselement für eine unbefugte Person unauffälliger am Haushaltsgerät angebracht ist.

Insbesondere vorteilhaft ist es auch, wenn an dem wenigstens einen Betätigungselement wenigstens ein zusätzlicher Verriegelungsmechanismus zum Schutz vor unbeabsichtigter Betätigung vorgesehen ist. Der Verriegelungsmechanismus kann vorzugsweise wenigstens teilweise Drehen des Betätigungselements um eine Hauptdrehachse senkrecht zur Bedienfläche und/oder wenigstens teilweise Eindrücken des Betätigungselements in Richtung der Bedienfläche und/oder eine Verriegelungseinrichtung wie eine Rastvorrichtung oder einen Verriegelungshebel umfassen. Dadurch wird das Betätigungselement selbst gesperrt und eine Betätigung des Betätigungselements zusätzlich erschwert.

Weiterhin kann es insbesondere vorteilhaft sein, wenn an dem wenigstens einen Betätigungselement wenigstens ein zusätzlicher Mechanismus, insbesondere ein Federmechanismus, zum Erschweren einer unbeabsichtigten Betätigung vorgesehen ist. Dadurch wird insbesondere für Kleinkinder, die noch nicht so viel Kraft aufbringen, die Betätigung erschwert, so dass ein optimaler Schutz vor unbeabsichtigter Betätigung geben ist.

Nach einem besonders bevorzugten Aspekt ist die erfindungsgemäße Vorrichtung als Kindersicherung ausgeführt.

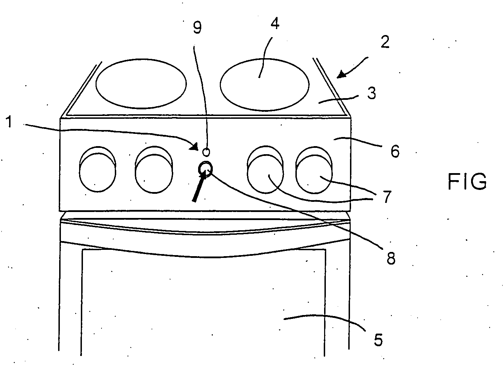

Die Erfindung wird im Folgenden anhand von Ausführungsbeispielen und unter Bezugnahme auf die beiliegende Zeichnung einer vorteilhafte Ausführungsform der Vorrichtung gemäß der Erfindung weiter erläutert.

Die FIG zeigt schematisch eine einfache, vorteilhafte Ausführungsform der Vorrichtung 1 gemäß der Erfindung. In der Zeichnung ist schematisch ein Ausschnitt eines Haushaltsgargeräts, in diesem Beispiel ein Elektroherd 2 mit einem Kochfeld 3 mit darauf befindlichen Kochzonen 4 und einem Back-, Gar- und Bratofen 5 dargestellt. Eine Bedienfläche 6 umfasst mehrere Bedienelemente 7, die als Schalter mit Drehknebeln ausgeführt sind zur Steuerung und Regelung der Funktionsart und/oder der Temperatur der Teilbereiche des Elektroherds, in diesem Fall der Kochzonen 4 und des Backofens 5.

An der Bedienfläche 6 ist auch die erfindungsgemäße Vorrichtung 1 angeordnet. Ein als Drucktaste ausgeführtes Betätigungselement 8 und eine Anzeigeeinheit 9 sind von einer Innenseite durch die Bedienfläche 6 durchgeführt, so dass sie von außen zugänglich sind. Drucktaste 8 und Anzeigeeinheit 9 schließen bündig mit der Bedienfläche 6 an ihrer Außenseite ab. Dadurch ist zum einen ein Reinigen der Bedienfläche 6 mit eingesetzter Drucktaste 8 erleichtert und zum anderen ist die Drucktaste 8 für unbefugte Personen unauffälliger als die restlichen Bedienelemente 7.

Die Anzeigeeinheit 9 umfasst eine LED mit zwei Leuchtfarben rot und grün, die an der Innenseite der Bedienfläche 6 angeordnet ist und durch die Öffnung in der Bedienfläche 6, die auch eine lichtdurchlässige Abdeckung aufweisen kann, nach außen hindurchleuchtet.

Betätigungselement 8, Anzeigeeinheit 9 bzw. LED und elektrische Schalteinrichtung sind in der hier beschriebenen Ausführungsform in einem Gehäuse zu einer Einheit zusammengefasst (hier nicht dargestellt), die von der Innenseite an der Bedienfläche montiert wird oder montierbar ist. Die Schalteinrichtung umfasst drei Microgap-Relais. Die Stromversorgung ist durch zwei der drei Eingangsphasen gewährleistet.

Durch Betätigen des Betätigungselements 8 in Pfeilrichtung über eine Mindestbetätigungsdauer von wenigstens 5 s wird bei der dargestellten Ausführungsform der Hauptsromkreis unterbrochen, so dass der Elektroherd 2 bzw. die Teilbereiche 4 und 5 über die Bedienelemente 7 nicht mehr in Betrieb genommen werden kann bzw. können. Sind alle Kontakte geöffnet, die Stromversorgung also unterbrochen, leuchtet die Anzeigeeinheit 9 bzw. die LED rot. Wird das Betätigungselement erneut für wenigstens 5 s betätigt, wird die Stromversorgung wieder hergestellt und die Anzeigeeinheit 9 bzw. die LED leuchtet grün.

Es ist auch möglich das Betätigungselement 8 so auszulegen, dass nur ein Teilbereich 4 oder 5 von der Stromversorgung abgetrennt werden kann. Wahlweise können auch mehrere Betätigungselemente 8 an der Bedienfläche 6 vorgesehen sein, um verschiedene der Teilbereiche 4 und 5 getrennt voneinander von der Stromversorgung abzukoppeln und wieder anzukoppeln.

### Bezugszeichenliste

- 1: Vorrichtung
- 2: Elektroherd
- 3: Kochfeld
- 4: Kochzone
- 5: Backofen
- 6: Bedienfläche
- 7: Bedienelement
- 8: Betätigungselement
- 9: Anzeigeeinheit

## Patentansprüche

1. Vorrichtung zur Sicherung eines Haushaltsgeräts, insbesondere eines Haushaltsgargeräts bzw. Haushaltsgarofens, vor unbeabsichtigtem Betrieb, umfassend
a) wenigstens ein Betätigungselement (8) und
b) wenigstens eine mit dem wenigstens einen Betätigungselement (8) zusammenwirkende elektrische Schalteinrichtung mit einer Zeitverzögerungsfunktion,
c) wobei durch Betätigen des wenigstens einen Betätigungselements (8) über eine vorgegebene oder vorgebbare Mindest-Betätigungsdauer in wenigstens einem Teilbereich (4, 5) des Haushaltsgeräts (2) durch die Schalteinrichtung eine Stromversorgung unterbrechbar bzw. unterbrochen oder herstellbar bzw. hergestellt ist oder wenigstens eine Schaltfunktion für das Haushaltsgerät (2) blockierbar bzw. blockiert oder freigebbar bzw. freigegeben ist.

2. Vorrichtung nach Anspruch 1,
wobei durch Betätigen des wenigstens einen Betätigungselements (8) über eine vorgegebene oder vorgebbare Mindest-Betätigungsdauer die Hauptstromversorgung für das Haushaltsgerät (2) unterbrechbar bzw. unterbrochen oder herstellbar bzw. hergestellt ist.

3. Vorrichtung nach Anspruch 1 oder Anspruch 2,
wobei das Betätigungselement (8) als Druckstaste und/oder Drehknebel ausgeführt ist.

4. Vorrichtung nach einem oder mehreren der vorhergehenden Ansprüche,
wobei wenigstens eine Anzeigeeinheit (9), insbesondere wenigstens eine Lampe oder eine LED umfassend, vorgesehen ist, zum Anzeigen des aktuellen Betriebszustands
des wenigstens einen Betätigungselements (8).

5. Vorrichtung nach Anspruch 4,
wobei einem Betätigungselement (8) wenigstens eine Lampe oder ein LED mit wenigstens zwei unterschiedlichen Leuchtfarben, insbesondere rot und grün, zugeordnet sind zum Anzeigen einer unterbrochen und einer hergestellten Stromversorgung durch das Betätigungselement (8).

6. Vorrichtung nach einem oder mehreren der vorhergehenden Ansprüche,
wobei als vorgegebene oder vorgebbare Mindest-Betätigungsdauer, um eine Schaltung auszulösen, wenigstens 2,0 s, vorzugsweise wenigstens 5,0 s,' vorgesehen sind.

7. Vorrichtung nach einem oder mehreren der vorhergehenden Ansprüche,
wobei die Mindest-Betätigungsdauer in einem vorgegebenen Bereich einstellbar ist.

8. Vorrichtung nach einem oder mehreren der vorhergehenden Ansprüche,
wobei das Betätigungselement (8) und die Schalteinrichtung und/oder die wenigstens eine Anzeigeeinheit (9) zu einer Einheit, insbesondere in einem Gehäuse, zusammengefasst sind.

9. Vorrichtung nach einem oder mehreren der vorhergehenden Ansprüche,
wobei das Betätigungselement (8) und/oder die wenigstens eine Anzeigeeinheit (9) an einer Bedienfläche (6) des Haushaltsgeräts (2) vorgesehen sind.

10. Vorrichtung nach einem oder mehreren der vorhergehenden Ansprüche,
wobei an dem wenigstens einen Betätigungselement (8) wenigstens ein Verriegelungsmechanismus zum Schutz vor unbeabsichtigter Betätigung vorgesehen ist.

11. Vorrichtung nach Anspruch 10,
wobei der Verriegelungsmechanismus wenigstens teilweise Drehen des Betätigungselements (8) um eine Hauptdrehachse senkrecht zu der Bedienfläche (6) und/oder wenigstens teilweise Eindrücken des Betätigungselements (8) in Richtung der Bedienfläche (6) und/oder eine Verriegelungseinrichtung umfasst.

12. Vorrichtung nach einem oder mehreren der vorhergehenden Ansprüche,
wobei an dem wenigstens einen Betätigungselement (8) wenigstens ein Mechanismus, insbesondere ein Federmechanismus, zum Erschweren einer unbeabsichtigten Betätigung'vorgesehen ist. ,

13. Vorrichtung nach einem oder mehreren der vorhergehenden Ansprüche,
die eine Kindersicherung ist.

14. Verfahren zur Sicherung eines Haushaltsgeräts, insbesondere eines Haushaltsgargeräts bzw. Haushaltsgarofens, vor unbeabsichtigtem Betrieb, insbesondere unter Verwendung einer Vorrichtung nach einem oder mehreren der vorhergehenden Ansprüche,
a) bei dem wenigstens ein Betätigungselement (8), vorzugsweise eine Drucktaste und/oder ein Drehknebel, bei Betätigung mit wenigstens einer elektrischen Schalteinrichtung mit einer Zeitverzögerungsfunktion zusammenwirkt, und
c) bei dem bei Betätigen des Betätigungselements (8) über eine vorgegebene oder vorgebbare Mindest-Betätigungsdauer in wenigstens einem Teilbereich (4, 5) des Haushaltsgeräts (2) eine Stromversorgung unterbrochen oder hergestellt wird oder wenigstens eine Schaltfunktion für das Haushaltsgerät (2) blockiert oder freigegeben wird.

15. Verfahren nach Anspruch 14,
bei dem durch Betätigen des wenigstens einen Betätigungselements (8)über eine vorgegebene oder vorgebbare Mindest-Betätigungsdauer die Hauptstromversorgung für das Haushaltsgerät (2) unterbrochen oder hergestellt wird.

16. Verfahren nach Anspruch 14 oder Anspruch 15,
bei dem der aktuelle Betriebszustand des wenigstens einen Betätigungselements (8) an wenigstens einer Anzeigeeinheit (9), insbesondere wenigstens einer Lampe oder einer LED, angezeigt wird.

17. Verfahren nach Anspruch 16,
bei dem eine unterbrochene und eine hergestellte Stromversorgung jeweils durch eine separate Leuchtfarbe, insbesondere rot und grün, angezeigt wird.

18. Verfahren nach einem oder mehreren der Ansprüche 14 bis 17,
wobei die vorgegebene oder vorgebbare Mindest-Betätigungsdauer, um eine Schaltung auszulösen, wenigstens 5 s beträgt.
